(19) Europäisches Patentamt
European Patent Office
Office européen des brevets

(11) **EP 4 080 999 B1**

(12) **EUROPÄISCHE PATENTSCHRIFT**

(45) Veröffentlichungstag und Bekanntmachung des Hinweises auf die Patenterteilung:
**04.06.2025   Patentblatt 2025/23**

(51) Internationale Patentklassifikation (IPC):
**H05K 1/02** (2006.01)

(21) Anmeldenummer: **21169730.5**

(52) Gemeinsame Patentklassifikation (CPC):
**H05K 1/0242;** H05K 2201/09272; H05K 2201/09727

(22) Anmeldetag: **21.04.2021**

(54) **HOCHFREQUENZ-ZULEITUNG UND ELEKTRONISCHE KOMPONENTE MIT HOCHFREQUENZ-ZULEITUNG**

HIGH-FREQUENCY FEED LINE AND ELECTRONIC COMPONENT WITH HIGH FREQUENCY FEED LINE

FIL HAUTE FRÉQUENCE ET COMPOSANTS ÉLECTRONIQUES POURVUS DE FIL HAUTE FRÉQUENCE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**26.10.2022   Patentblatt 2022/43**

(73) Patentinhaber: **SCHOTT AG**
**55122 Mainz (DE)**

(72) Erfinder:
• **Krause, Andreas**
**84186 Vilsheim (DE)**

• **Droegemüller, Karsten**
**82223 Eichenau (DE)**

(74) Vertreter: **Blumbach · Zinngrebe Patentanwälte PartG mbB**
**Alexandrastraße 5**
**65187 Wiesbaden (DE)**

(56) Entgegenhaltungen:
WO-A1-2007/000934          WO-A1-2014/089823
DE-A1- 102005 038 456

## Beschreibung

Gebiet der Erfindung

Die Erfindung bezieht sich allgemein auf Hochfrequenz-Zuleitungen. Insbesondere bezieht sich die Erfindung auf Hochfrequenz-Zuleitungen mit Veränderungen der Richtung des Verlaufs. Ferner bezieht sich die Erfindung auf elektronische Komponenten mit solchen Hochfrequenz-Zuleitungen.

Hintergrund der Erfindung

Hochfrequenz-Zuleitungen sind grundsätzlich bekannt. Insbesondere werden derartige Zuleitungen benötigt, um elektronische Komponenten mit Daten zu versorgen. Dies wird beispielsweise in der Anmeldung DE 10 2020 105 772.5 der Anmelderin beschrieben.

In solchen Fällen werden auf einem Submount angeordnete Hochfrequenz-Zuleitungen verwendet, die einen Signal-Leiter und einen Masseleiter umfassen.

Derartige Leiterbahnen und ihre Eigenschaften sind beispielsweise beschrieben in Agilent Technologies, Advanced Design System 1.5, Circuit Components, Distributed Components, Kapitel 2 (Zu finden unter der Internetadresse http://literature.cdn.keysight.com/litweb/pdf/ads15/ccdist/ccdist026.html).

WO 2007/000934 AI und DE 10 2005 038456 AI offenbaren Leiterbahnanordnungen für hochfrequente Signale, mit einem auf dem Träger angeordneten schichtförmigen flachen Signalleiter, wobei die Außenkante und die Innenkante im Umlenkbereich des Signalleiters zumindest abschnittsweise gekrümmt sind. WO 2014/089823 AI offenbart eine andere Variante der Gestaltung des Umlenkbereichs.

Je nach Anordnung und Verschaltung der zu versorgenden Komponenten kann aus Geometriegründen eine Richtungsänderung der Leitungen erforderlich sein. Hierbei besteht das Problem, dass es durch die Umlenkung zu Kapazitätsänderungen entlang der Leitung kommen kann. Diese Kapazitätsänderungen können zu einer unerwünschten erhöhten Rückflussdämpfung (engl.: "return loss") führen. Eine abrupte 90°-Änderung führt sogar zu erheblicher Reflexion. Soll sich die Richtung um 90° ändern, so ist nach dem Stand der Technik vorgesehen, dass die Außenseite der Leiterbahn zur bisherigen und zur neuen Ausbreitungsrichtung jeweils in einem Umlenkwinkel von 45° steht, so dass ein zu beiden Ausbreitungsrichtungen schräg stehender Umlenkabschnitt, beziehungsweise eine Fase entsteht. Eine weitere Möglichkeit ist das Vorsehen eines abgerundeten Leitungsabschnitt. Diese Möglichkeit hat aber den Nachteil, mehr Platz zu benötigen.

Nachteilig bei einer Gestaltung der Umlenkung mit einer 45°-Fase ist andererseits, dass der Umlenkabschnitt als Antenne wirkt, so dass im Umlenkbereich des Leiters Reflexionsverluste auftreten. Auch wird durch eine solche Gestaltung der Umlenkung die Bandbreite der auf dem Leiter übertragbaren Hochfrequenzsignale begrenzt.

Neben Reflexionsverlusten können bei sehr hohen Frequenzen auch Wellen höherer Ordnung auftreten, beziehungsweise sich ab einer bestimmten Grenzfrequenz ausbreiten, sodass sich nicht nur die Grundwelle, sondern auch Wellen höherer Ordnung auf der Leitung ausbreiten. Die Grundwelle und alle Wellen höherer Ordnung werden als Eigenwellen der Leitung bezeichnet. Auf einer ungestörten Leitung sind die Eigenwellen unabhängig und stören sich nicht. Bei einer Störung tritt allerdings eine Verkopplung der Eigenwellen auf, sodass sich auch die Eigenschaften der Grundwelle ändern, sobald sich eine Welle höherer Ordnung ausbreitet. Ist eine Leitung also nicht mehr gleichförmig oder inhomogen in Ausbreitungsrichtung, werden Wellen höherer Ordnung angeregt. Eine Richtungsänderung stellt eine solche Inhomogenität dar. Bei einem Leitungswinkel spricht man daher auch von einer Diskontinuität. Bei der zuvor genannten 45°-Fase wird eine Kompensation der Kapazität durch die Abschrägung, also durch eine abrupte Änderung des Leiterbahnquerschnitts erreicht. Deshalb werden bei entsprechend hohen Frequenzen bei diesem Leitungswinkel Wellen höhere Ordnung angeregt.

Daher liegt der Erfindung die Aufgabe zugrunde, eine Hochfrequenz-Zuleitung bereitzustellen, die im Vergleich zum Stand der Technik geringere Reflektionsverluste in Umlenkbereichen sowie vorzugsweise auch eine höhere Grenzfrequenz für Wellen höherer Ordnung aufweist und die Nutzung einer im Vergleich zum Stand der Technik höheren Bandbreite erlaubt.

Diese Aufgabe wird durch den Gegenstand der unabhängigen Ansprüche gelöst. Weitere Ausführungsformen und vorteilhafte Weiterbildungen der Erfindung sind Gegenstand der Unteransprüche.

Demgemäß ist eine Leiterbahnanordnung für hochfrequente Signale vorgesehen, mit einem Träger und einem auf dem Träger angeordneten, durch zumindest eine Innenkante und zumindest eine Außenkante begrenzten schichtförmigen Signalleiter, welcher sich von einem Ende zu einem anderen Ende des Signalleiters erstreckt, wobei der Signalleiter der Leiterbahnanordnung in einem Umlenkbereich zwischen den Enden seine Richtung ändert und eine minimale Breite aufweist, wobei die minimale Breite im Umlenkbereich des Signalleiters kleiner ist, als die Breiten an den Enden des Signalleiters, wobei die Außenkante und die Innenkante im Umlenkbereich zumindest abschnittsweise gekrümmt sind, und wobei die Krümmung der Innenkante und die Krümmung der Außenkante jeweils ein Zentrum besitzen, wobei das Zentrum der Krümmung der Innenkante und das Zentrum Krümmung der Außenkante versetzt zueinander angeordnet sind, sodass die Krümmung der Innenkante und die Krümmung der Außenkante exzentrisch zueinander ausgebildet ist, sich insbesondere die Zentren voneinander unterscheiden. Durch die Krümmung kann im Umlenkbereich weniger Metall für den Signalleiter verwendet werden, wodurch die üblicherweise erhöhte Kapazität im Umlenkbereich kompensiert werden kann. Vorteilhafterweise sind die Außenkante und die Innenkante im Umlenkbereich zumindest abschnittsweise gekrümmt.

Hierdurch kann die im Umlenkbereich erhöhte Kapazität stärker kompensiert werden.

In einem Beispiel, der nicht Teil der Erfindung ist, ist vorgesehen, dass die minimale Breite gegenüber der Breite an einem der Enden des Signalleiters um einen Faktor im Bereich von 0,5 bis 0,95, vorzugsweise im Bereich von 0,6 bis 0,8 reduziert ist.

Um die Kompensation der Kapazität individuell anpassbar zu gestalten, ist zumindest eines der folgenden Merkmale vorgesehen:

- der Radius der Krümmung der Außenkante ist größer, als der Radius der Krümmung der Innenkante,
- die Krümmung der Außenkante und/oder der Innenkante ist kontinuierlich, insbesondere ununterbrochen ausgebildet,
- die Krümmung der Außenkante und/oder der Innenkante ist stetig,
- die Krümmung der Außenkante und/oder der Innenkante ist unstetig
- die Breite des Signalleiters ändert sich im Umlenkbereich stetig, wobei der Verlauf der Breite vorzugsweise mindestens zwei Mal stetig differenzierbar ist,
- die minimale Breite des Signalleiters liegt innerhalb des mittleren Drittels des Umlenkbereichs, vorzugsweise in der Mitte des Umlenkbereichs.

Die Breite des Signalleiters im Umlenkbereich, beziehungsweise zwischen mindestens einer gekrümmten Kante und der anderen Kante, vorzugsweise zwischen zwei gekrümmten Kanten ist im Sinne der Erfindung definiert durch den Abstand einer Tangente der Innenkrümmung der Innenkante zur Tangente der Innenkrümmung der Außenkante, insbesondere definiert durch eine gemeinsame Senkrechte der Tangente der Innenkrümmung der Außenkante und der Tangente der Innenkrümmung der Innenkante. Bevorzugt steht die eine Senkrechte in diesem Fall senkrecht, also in einem 90°-Winkel zu den beiden Tangenten der Innenkrümmungen, wobei die Länge der Senkrechten, der Breite des Signalleiters, beziehungsweise dem Abstand der Innenkanten zur Außenkante entspricht.

Die Krümmung der Innenkante und die Krümmung der Außenkante sind exzentrisch zueinander, insbesondere nicht konzentrisch ausgebildet, und vorzugsweise derart, dass die Breite des Signalleiters im Umlenkbereich geringer ist, als an einem Ende, bevorzugt beiden Enden des Signalleiters. Dies führt zu einer Erhöhung der Grenzfrequenz der Wellen höherer Ordnung, sodass die Wellen höherer Ordnung erst bei einer höheren Frequenz entstehen und die Grundwelle nicht mehr, oder nur wenig gestört wird. Wenn die Breite des Signalleiters sich stetig ändert und/oder die Außenkante und die Innenkante durchgehendkann zudem ein Kapazitätssprung vermieden werden, und daher auch eine Kapazitätskompensation erfolgen ohne abrupten Sprung des Leiterbahn-querschnittes.

Vorteilhafterweise kann die Form des Signalleiters auch an die geometrische Ausgestaltung des Submounts angepasst werden, ohne auf die vorgenannten Vorteile verzichten zu müssen. Hierzu ist vorgesehen, dass der Signalleiter im Umlenkbereich, beziehungsweise der Umlenkbereich ist asymmetrisch geformt, oder symmetrisch, insbesondere derart, dass der Umlenkbereich eine Spiegelachse entlang der Winkelhalbierenden des Umlenkwinkels aufweist. Der Umlenkbereich kann sich auch von einem Ende bis zum anderen Ende des Signalleiters erstrecken. Auf diese Weise kann der Signalleiter beispielsweise über seine gesamte Länge gebogen geformt sein, sodass die Signalleitung nicht durch einen Knick gestört wird.

Gemäß einem weiteren Beispiel, der nicht Teil der Erfindung ist, ist eine Leiterbahnanordnung für hochfrequente Signale vorgesehen, mit einem Träger und einem auf dem Träger angeordneten, durch zwei Kanten begrenzten schichtförmigen Signalleiter, sowie einen auf dem Träger angeordneten Masseleiter, wobei der Signalleiter der Leiterbahnanordnung in einem Umlenkbereich zwischen zwei Schenkeln seine Richtung ändert, wobei im Umlenkbereich zumindest eine der Kanten des Signalleiters mindestens zwei Umlenkabschnitte aufweist, die in einem Winkel zueinander stehen. Demgemäß ist eine mindestens zweistufige Umlenkung der Kante in die neue Richtung vorgesehen.

Es zeigt sich überraschend, dass auf diese Weise nicht nur die Rückflussdämpfung reduziert werden kann. Mit der Ausgestaltung der Umlenkabschnitte kann auch eine Feinjustierung vorgenommen werden, so dass die Impedanz an die vorgesehene Signalfrequenz angepasst werden kann.

Um die vorgenannten Vorteile der Reduzierung der Rückflussdämpfung und der reduzierten Kapazität zu kombinieren, kann es auch vorgesehen sein, dass eine Kante, beispielsweise die Innen- oder Außenkante zumindest abschnittsweise gekrümmt ist und die andere Kante, vorzugsweise die Außenkante oder Innenkante mindestens zwei oder mehr Umlenkabschnitte aufweist.

In einer besonders bevorzugten Ausgestaltung wird der Signalleiter um 90°, oder um einen Winkel nahe von 90° umgelenkt. Im Speziellen ist dabei vorgesehen, dass die Umlenkung im Umlenkbereich um einen Winkel im Bereich von 75° bis 105°, vorzugsweise wie gesagt 90° erfolgt.

Vorteilhafterweise ist die Leiterbahnanordnung als Microstrip-Line, als koplanarer Wellenleiter oder als CBCPW-Anordnung ausgebildet ist. Bevorzugt wird eine als Microstrip-Line ausgebildete Leiterbahnanordnung. Dies ermöglicht eine besonders kompakte Bauweise, sowie insbesondere auch eine einfache Herstellung mit vergleichsweise wenigen Fertigungsschritten.

Die Leiterbahnanordnung ist umfasst hierzu vorzugsweise einen insbesondere schichtförmigen Masseleiter, welcher gegenüber dem schichtförmigen Signalleiter angeordnet ist, wobei für den Abstand zwischen Masseleiter und Signalleiter zumindest eines der folgenden Merkmale gilt:

- der Abstand liegt im Bereich von 0,025 mm und 0.5mm, vorzugsweise im Bereich von 0,05 mm bis 0,4mm,
- die Breite an einem Ende des Signalleiters ist um einen Faktor im Bereich von 0.5 bis 7.5, vorzugsweise in einem Bereich von 0.6 bis 5 größer als der Abstand zwischen Masseleiter und Signalleiter,
- Das Verhältnis des Abstands zwischen Signalleiter und Masseleiter zur Differenz der Breite des Signalleiters an einem seiner Enden (35, 36) und der minimalen Breite des Signalleiters hat einen Wert im Bereich von 0,5 bis 2.

Diese Bereiche sind besonders günstig bei vorgesehenen Impedanzen zwischen 15 Ohm und 65 Ohm, insbesondere zwischen 20 Ohm und 60 Ohm oder sogar bei genau 20 Ohm oder 60 Ohm. Bevorzugt werden derartige Wertebereiche, wenn der Signalleiter auf einem Submount aus Glas oder Keramik, insbesondere $Al_2O_3$ angeordnet ist, wobei der Submount eine Dicke zwischen 0,025mm und 0,5mm aufweisen kann.

Da die Breite des Signalleiters und der Abstand des Signalleiters zum Masseleiter in hohem Maße die Kapazität beeinflussen, kann die Kapazität mit den vorgenannten Werten dieser Parameter optimal auf eine gewünschte Anwendung, insbesondere jedoch auf eine besonders gute Signalübertragung bei sehr hohen Frequenzen, beispielsweise bei über 80 GHz eingestellt werden. Die Leiterbahnanordnung ist daher derart ausgebildet ist, dass eine Grenzfrequenz, insbesondere der Entstehung von Wellen höherer Ordnung oberhalb von 60 GHz, vorzugsweise oberhalb von 70 GHz liegt. Dies betrifft besonders die Ausbildung der Leitungskrümmung des Signalleiters und/oder eine verringerte Breite $W_{min}$ im Umlenkbereich, insbesondere in Verbindung mit gekrümmten Kanten 2, 3. Die Erfindung wird nachfolgend anhand der beigefügten Figuren näher erläutert.

<u>Kurzbeschreibung der Figuren:</u>

Fig. 1 zeigt die Geometrie einer Leiterbahnanordnung mit einer 45° - Umlenkung nach dem Stand der Technik.

In den Fig. 2 bis 4 sind verschiedene Konfigurationen von Leiterbahnanordnungen gezeigt.

Fig. 5 zeigt ein Diagramm mit der in einem breiten Frequenzbereich aufsummierten Rückflussdämpfung als Funktion des Umlenkwinkels.

Fig. 6 zeigt eine elektronische Komponente.

Fig. 7 zeigt eine Leiterbahnanordnung mit zwei gekrümmten Kanten, bei der der Signalleiter eine konstante Breite aufweist.

Fig. 8 zeigt in zwei Teilbildern Leiterbahnanordnungen mit zwei gekrümmten Kanten, bei denen der Signalleiter im Umlenkbereich schmaler ist, als an den Enden des Signalleiters.

Fig. 9 zeigt eine Konstruktion zur Ermittlung einer gewünschten Breite des Signalleiters im Umlenkbereich.

Fig. 10 zeigt die Einfügungsdämpfung als Funktion der Signalfrequenz für einen Signalleiter mit einer 45° Anschrägung bei Verwendung in einem Transistor-Outline-Gehäuse (TO-Gehäuse).

Fig. 11 zeigt die Reflexionsdämpfung als Funktion der Signalfrequenz für einen Signalleiter mit einer 45° Anschrägung bei Verwendung in einem TO-Gehäuse.

Fig. 12 zeigt die Einfügungsdämpfung als Funktion der Signalfrequenz für einen Signalleiter mit konstanter Leitungsbreite und gekrümmten Kanten bei Verwendung in einem TO-Gehäuse.

Fig. 13 zeigt die Reflexionsdämpfung als Funktion der Signalfrequenz für eine Signalleiter mit konstanter Leitungsbreite und gekrümmten Kanten bei Verwendung in einem TO-Gehäuse.

Fig. 14 zeigt die Einfügungsdämpfung als Funktion der Signalfrequenz für einen Signalleiter mit variabler Leitungsbreite und gekrümmten Kanten bei Verwendung in einem TO-Gehäuse.

Fig. 15 zeigt die Reflexionsdämpfung als Funktion der Signalfrequenz für eine Signalleiter mit variabler Leitungsbreite und gekrümmten Kanten bei Verwendung in einem TO-Gehäuse.

Fig. 16 zeigt die Einfügungsdämpfung und die als Funktion der Signalfrequenz für verschiedene Signalleitergeometrien auf einem dicken Submount.

Fig. 17 zeigt die Reflexionsdämpfung als Funktion der Signalfrequenz für verschiedene Signalleitergeometrien auf einem dicken Submount.

Fig. 18 zeigt die Einfügungsdämpfung als Funktion der Signalfrequenz für verschiedene Signalleitergeometrien auf einem dünnen Submount.

Fig. 19 zeigt die Reflexionsdämpfung als Funktion der Signalfrequenz für verschiedene Signalleitergeometrien auf einem dünnen Submount.

Fig. 20 zeigt schematisch einen Signalleiter zur Verwendung in einem TO-Gehäuse.

Fig. 21 zeigt in drei Teilbildern einen Submount im Querschnitt mit unterschiedlichen elektrischen Feldern.

Detaillierte Beschreibung der Erfindung

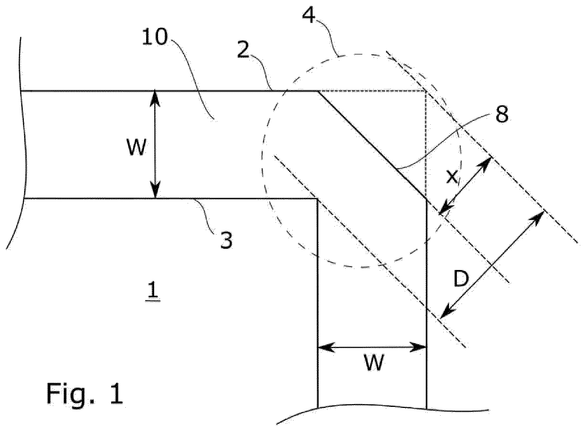

Fig. 1 zeigt den Signalleiter 10 einer Leiterbahnanordnung 1 mit einer Umlenkung um 90° in Bezug auf die bisherige und die neue Ausbreitungsrichtung in einem Umlenkbereich 4, beziehungsweise einen Umlenkbereich mit einer Anschrägung der Außenkante. Der leiterbahnförmige oder schichtförmige Signalleiter 10 weist eine Außenkante 2 und eine Innenkante 3 auf. Im Umlenkbereich 4 knickt die Außenkante 2 um einen Umlenkwinkel von 45° zur bisherigen Ausbreitungsrichtung ab, so dass die Kontur des Leiters eine Anschrägung 8 aufweist.

Wenn der Signalleiter 10, wie in Fig. 1 gezeigt, eine Breite W aufweist, so weist eine eckige Verbindung eine Breite D des Signalleiters entlang der Spiegelachse auf, die durch die Anschrägung um einen Wert X und aufgrund der beschriebenen Ausgestaltung der Umlenkung eine Gehrung X entsteht. Für die optimale Gehrung gilt gemäß der genannten Quelle von Agilent Technologies:

$$(1)\ \frac{X}{D} = 0,52 + 0,65 \times e^{-1,35 \times W/H}$$

H bezeichnet dabei die Dicke der Leiterbahn. Für D gilt offensichtlich D = $\sqrt{2} \times W$.

Für typische Dimensionen von W = 500 $\mu$m und H = 150 $\mu$m erhält man für die Gehrung X:

$$X = 372,8\ \mu m$$

Dies wird weiter als Referenzmodell verwendet.

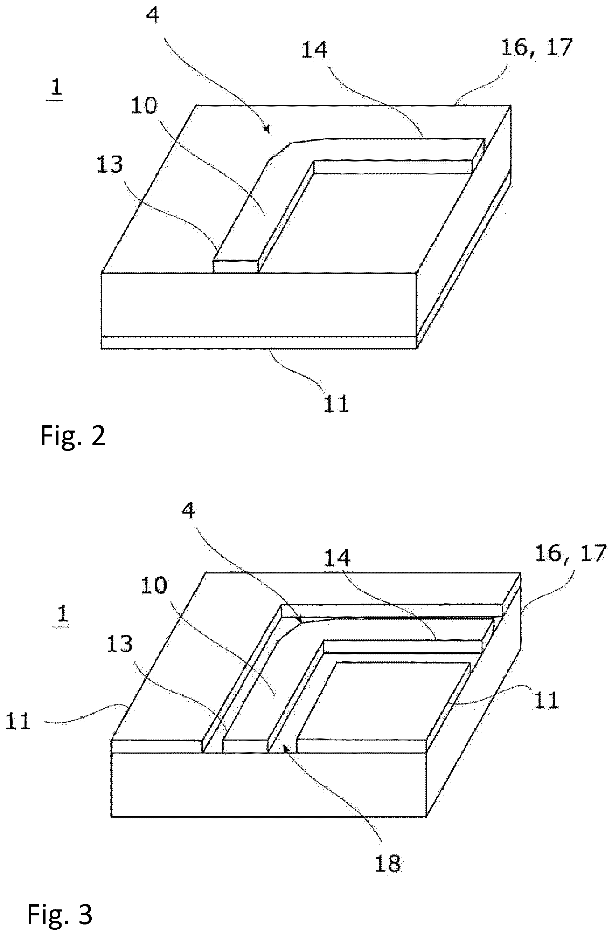

In den Fig. 2 bis 4 werden bevorzugte Konfigurationen von Leiterbahnanordnungen 1 gezeigt. Ein Beispiel einer besonders bevorzugten Konfiguration zeigt Fig. 2. Der Signalleiter 10 und der Masseleiter 11 sind auf gegenüberliegenden Seiten des Trägers 16 angeordnet. Eine solche Konfiguration ist dem Fachmann prinzipiell als sogenannte Mikrostreifenleitung bekannt. Generell kann der Träger 16 ein Submount 17 sein. Ein solcher Submount kann auf einem Sockel eines Gehäuses für eine elektronische Komponente angeordnet sein. Gedacht ist hier insbesondere an einen Sockel für ein TO-Gehäuse (TO=Transistor Outline).

Der Submount 17 kann beispielsweise aus Aluminiumnitrid-Keramik oder allgemeiner einer Aluminiumnitrid enthaltenden Keramik gefertigt sein. Auch andere Materialien mit guter thermischer Leitfähigkeit können verwendet werden, beispielsweise Glas, oder Glas und Keramik. Für die Hochfrequenzzuleitung kann auch ein Submount aus Glas verwendet werden. Aufgrund der geringen Dicke kann besonders Dünnglas geeignet sein. Bei Dicken des Submounts unter 0.2mm kann beispielsweise die deutlich schlechtere Wärmeleitfähigkeit zum Teil kompensiert werden. Entscheidend ist der sogenannte Thermische Widerstand. Je dünner ein Substrat, desto geringer ist dessen thermischer Widerstand.

Die Konfiguration der Fig. 3 basiert darauf, dass der Signalleiter 10 und der Masseleiter 11 auf der gleichen Seite des Trägers 16 angeordnet sind. Der Signalleiter 10 verläuft dabei in einem Spalt 18 im Masseleiter 11. Das Beispiel stellt damit eine koplanare Leiterbahnanordnung (CPW="coplanar waveguide") dar.

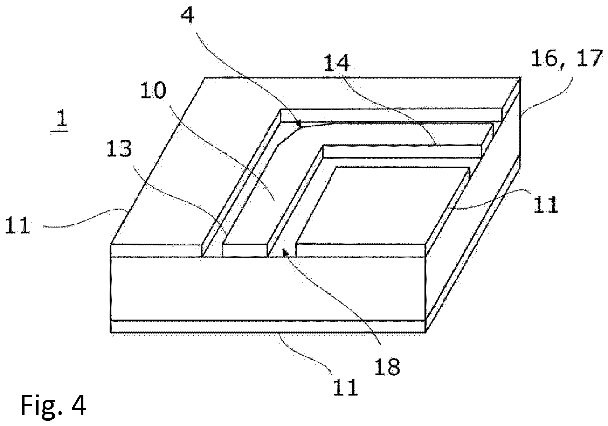

Eine Variante einer koplanaren Leiterbahnanordnung 1 zeigt Fig. 4. Hierbei ist zusätzlich zu den koplanaren zum Signalleiter 10 angeordneten Leiterbahnen des Masseleiters 11 auch eine auf der gegenüberliegenden Seite des Trägers 16 angeordnete Leiterbahn des Masseleiters 11 vorhanden. Eine solche Anordnung wird als CBCPW ("conductor backed coplanar waveguide") bezeichnet. Alle Ausführungsbeispiele haben gemeinsam, dass die Umlenkung mindestens zweistufig erfolgt.

Für die Leiterbahnanordnungen wurden folgende Modellparameter zugrunde gelegt: Der Träger, auf dem die als Microstrip ausgebildete Leiterbahnanordnung aufgebracht ist, besteht aus Aluminiumnitrid-Keramik mit einer Permittivität von 8,8. Der dielektrische Verlustfaktor tan($\delta$) beträgt 0,001. Die Leiterbahnen, insbesondere der Signalleiter 10 ist aus Gold gefertigt. Die Leitfähigkeit der Gold-Leiterbahn beträgt 41000000 Siemens/m.

Wie anhand der Kurven zu erkennen ist, zeigt die einfache 45°-Anschrägung die höchsten Verluste. Bei hohen Signalfrequenzen zwischen 30 GHz und 45 GHz zeigt die Anordnung mit einem Umlenkwinkel von 30° eine besonders niedrige Dämpfung. Um die Winkelabhängigkeit der Reflexionsdämpfung im gesamten Hochfrequenzbereich bewerten zu können, wurden die Dämpfungen mag(S11(f)) für Frequenzen $f_n$ im Bereich von 1 GHz bis 50 GHz aufsummiert:

$$(3) \qquad S = \sum_{f_n=1GHz}^{50GHz} mag(S_{11}(f_n))$$

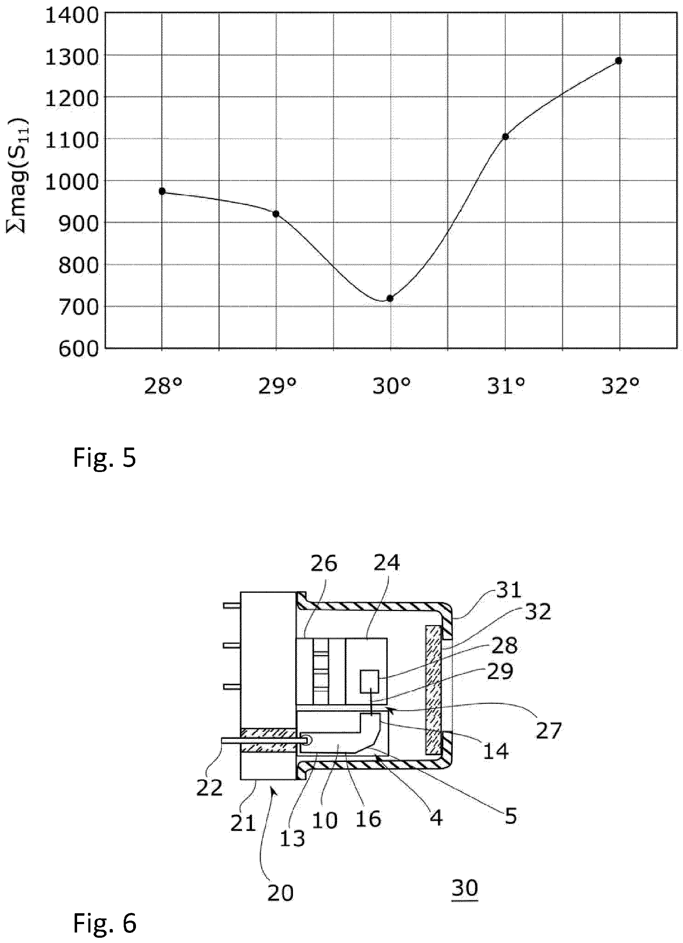

Das Ergebnis dieser Summation ist in Fig. 5 dargestellt. Fig. 5 zeigt ein Diagramm mit der im Frequenzbereich von 1 GHz bis 50 GHz in Schritten von 220 MHz aufsummierten Amplituden, beziehungsweise Absolutbeträge mag($S_{11}$) der Rückflussdämpfung $S_{11}$ für die verschiedenen Umlenkwinkel von 28° bis 32°. Der Verlauf der gezeigten Kurve zeigt ein deutliches Minimum für einen Umlenkwinkel von 30°. Die aufsummierte Rückflussdämpfung am Umlenkabschnitt gemäß Gleichung (3) beträgt bei Umlenkwinkeln im Bereich von 28° bis 30° weniger als 1000. Solche Werte können auch mit anderen Geometrien von Umlenkbereichen mit mehreren Umlenkabschnitten entlang einer Kante erreicht werden. Daher ist allgemein in einer Ausführungsform vorgesehen, dass der Umlenkbereich 4 so geformt ist, dass die Summe S der Größen des Streuparameters S11 für Frequenzen im Abstand von 1 GHz gemäß Gleichung (3) in einem Frequenzbereich von 1 GHz bis 50 GHz kleiner als 1000 beträgt.

Durch diese Wahl der Umlenkwinkel und ungleicher Länge der Umlenkabschnitte werden die folgenden Vorteile erzielt:

Es wird, im Vergleich zu einer einfachen 45°-Umlenkung gemäß dem Stand der Technik, eine bessere Steuerung der Kapazität der Ecke der Leiterbahn im Umlenkbereich erreicht. Dies erhöht die Bandbreite der zur Datenübermittlung genutzten Signal. Aufgrund des Minimums um einen Umlenkwinkel von 30° ist gemäß einer Ausführungsform allgemein vorgesehen, dass der Umlenkwinkel einer Kante 2, 3, vorzugsweise der äußeren Kante 3 am Übergang von einem Schenkel 13, 14 des Signalleiters 10 zum angrenzenden Umlenkungsabschnitt 5 zwischen 29° und 31° beträgt.

Diese Offenbarung betrifft allgemein auch elektronische Bauelemente, welche in einem Gehäuse verbaut und zur Übermittlung hochfrequenter elektrischer Signale mit der hier beschriebenen Leiterbahnanordnung verbunden sind. Ein Bestandteil des Gehäuses ist typischerweise ein Sockel, auf dem das elektronische Bauelement befestigt und über welchen die Signalzuführung erfolgt. Allgemein ist dazu ein Sockel 20 für ein elektronisches Bauteil mit einem elektronischen Bauelement 28 und einer Leiterbahnanordnung 1 gemäß dieser Offenbarung vorgesehen, wobei der Sockel eine elektrische Durchführung 22 aufweist, und wobei das elektronische Bauelement 28 und die elektrische Durchführung 22 beide mit dem Signalleiter 10 der Leiterbahnanordnung 1 verbunden sind, so dass elektrische Signale von der Durchführung 22 über den Signalleiter 10 zum Bauelement 28 geleitet werden. Insbesondere erfolgt der Anschluss von Durchführung 22 und elektronischem Bauelement an jeweils einem der Schenkel 13, 14, so dass die elektrischen Signale nacheinander einen Schenkel, den Umlenkungsbereich 4 und dann den anderen Schenkel durchfließen.

Weiterhin betrifft diese Offenbarung auch eine elektronische Komponente mit einem Sockel. Die elektronische Komponente 30 ist ein Bauteil mit einem Gehäuse, in welchem das elektronische Bauelement 28 und die Leiterbahnanordnung 1 eingeschlossen sind. Insbesondere kann das Gehäuse einen Sockel 20 und eine Kappe 31 umfassen.

Eine elektronische Komponente 30 mit einem solchen Sockel 20 zeigt schematisch Fig. 6. Als elektronisches Bauelement 28 in der elektronischen Komponente 30 wird vorzugsweise ein optoelektronischer Wandler verwendet. So kann das elektronische Bauelement 28 eine Laserdiode sein, um hochfrequente elektrische Signale für die optische Signalübertragung zu wandeln. Umgekehrt kann das elektronische Bauelement 28 auch eine Photodiode sein, um optisch übertragene Daten zurück in elektrische Signale zu wandeln.

Das Gehäuse der elektronischen Komponente 30 kann beispielsweise ein TO-Gehäuse sein (TO="Transistor Outline"). Für einen optoelektronischen Wandler als elektronisches Bauelement 28 kann die mit dem Sockel 20 verbundene Kappe 31 ein Fenster 32 aufweisen. Beispielsweise kann das Fenster 32 mit dem Blech der Kappe 31 mittels eines Glaslots verbunden sein.

Je nachdem, in welche Richtung die Signale gewandelt werden, wird eine Signalleitungsrichtung definiert. Bei einem elektro-optischen Wandler wie einer Laserdiode ist die Signalleitungsrichtung entlang des Signalleiters 10 von der Durchführung 22 aus zur Laserdiode. Um eine gute Reflexionsdämpfung zu erreichen, ist es dabei generell, ohne Beschränkung auf das dargestellte Beispiel besonders bevorzugt, wenn der an den zuerst von den elektrischen Signalen durchflossene Schenkel 13 angrenzende Umlenkungsabschnitt 5 zur Kante, vorzugsweise zur äußeren Kante 3 des Schenkels 13 einen Umlenkwinkel von weniger als 45°, vorzugsweise weniger als 40° aufweist. Welcher Schenkel 13, 14 zuerst von den elektrischen Signalen durchflossen wird, wird dabei durch die Signalleitungsrichtung bestimmt.

Eine Umlenkung des Signalleiters 10, wie sie in dieser Offenbarung beschrieben wird, kann etwa dann von Vorteil sein, wenn das elektronische Bauelement 28 thermisch vom Sockel 20 entkoppelt werden soll. Dazu kann gemäß einer Ausführungsform vorgesehen sein, dass die elektronische Komponente 28 auf einem Podest 24 angeordnet ist, welches mit einem thermoelektrischen Kühler 26 gekühlt wird, wobei der Träger 16 mit dem Signalleiter 10 neben dem Podest 24 und vom Podest 24 durch einen Spalt 27 getrennt angeordnet ist. Der Spalt 27 verhindert einen thermischen Kontakt zum Träger 16 der Leiterbahnanordnung 1. Durch diese Anordnung verläuft dann aber der Signalleiter neben dem thermoelektrischen Kühlelement 26 und dem Podest. Die Umlenkung dient dann dazu, den Signalleiter 10 in Richtung zum elektronischen Bauelement 28 zu führen, wie anhand des Beispiels der Fig. 6 ersichtlich ist.

Der Spalt 27 kann dann mit einem an einem Ende des Signalleiters 10, insbesondere am Ende des Schenkels 14 angebrachten Bonddraht 29 überbrückt werden. Dabei erfolgt die elektrische Verbindung zum elektronischen Bauelement 28 wie im Beispiel dargestellt von der Durchführung 22 zu einem ersten Schenkel 13 des Signalleiters 10, über den Umlenkbereich 4 zum zweiten Schenkel 14 bis zum Ende des Signalleiters 14, welches typischerweise auch das Ende des zweiten Schenkels 14 ist, und vom Ende des Signalleiters 14 über den Bonddraht 29. Der Bonddraht 29 kann das elektronische Bauelement 29 direkt kontaktieren, oder die Verbindung zu einer weiteren Leiterbahn auf dem Podest 24 herstellen. Bei dem in Fig. 6 gezeigten Beispiel ist das elektronische Bauelement 28 direkt mit dem Bonddraht 29 verbunden.

Es ist dem Fachmann ersichtlich, dass die Leiterbahnanordnung 1, sowie der Sockel 20 mit der Leiterbahnanordnung und die mit dem Sockel 20 gebildete elektronische Komponente nicht auf die speziellen dargestellten Beispiele beschränkt sind. So kann sich an einen oder beide Schenkel 13, 14 auch über einen weiteren Umlenkbereich ein zusätzlicher Schenkel anschließen. Auf diese Weise kann der Signalleiter beispielsweise U-förmig sein, oder der weitere Schenkel verläuft seitlich versetzt parallel zum ersten Schenkel. Weiterhin ist es auch denkbar, auf dem Träger 16 zwei oder mehr Signalleiter 10 vorzusehen. So können gemäß einer Ausführungsform diese Signalleiter 10 koplanar auf einer der Seiten des Trägers 16 verlaufen, wobei auf der gegenüberliegenden Seite ein gemeinsamer Masseleiter vorhanden ist.

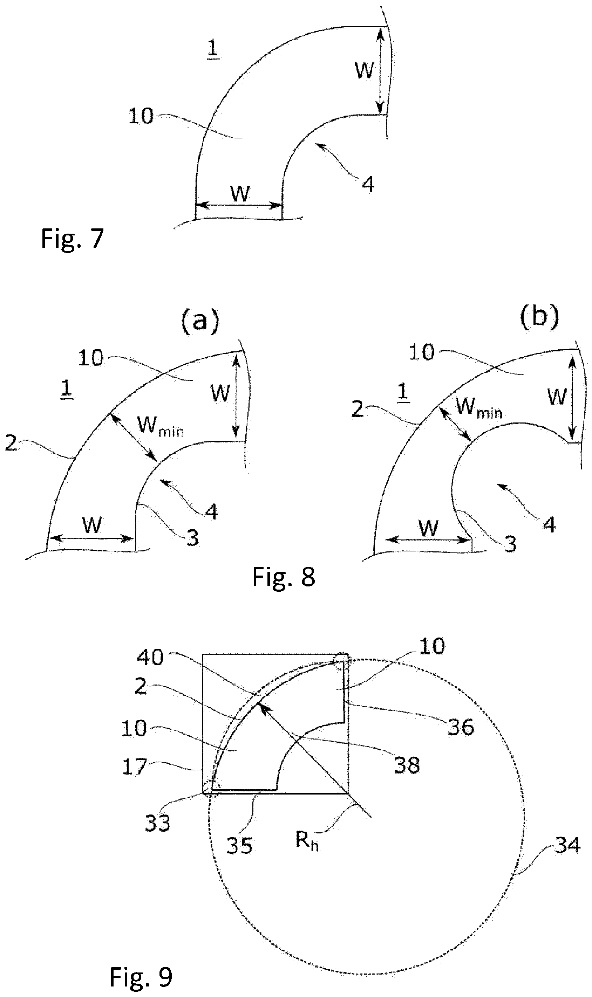

Aus dem Stand der Technik sind zwar Signalleiter bekannt, bei denen beide Kanten gekrümmt sind, jedoch ändern sich deren Querschnittsbreiten der Leiterbahn nicht während der Krümmung, wie dies beispielsweise in Fig. 7 gezeigt ist. Aufgrund der kontanten Querschnittsbreite weist die Krümmung eine erhöhte Kapazität auf, welche die Leitungsimpedanz ändert. Damit ist eine Fehlanpassung der Leitung verbunden, was zu einer höheren Reflexionsdämpfung des Signals in der Krümmung führt. Dies wird dadurch vermieden, dass sich die Breite des Signalleiters im Umlenkbereich 4 ändert, wodurch die Kapazität an die benötigte Impedanz angepasst, insbesondere verringert wird.

Fig. 8a und 8b zeigen daher eine Leiterbahnanordnung 1 mit zwei gekrümmten Kanten, bei der der Signalleiter im Umlenkbereich 4 schmaler ist, als an den Enden des Signalleiters 10. Am Anfang, beziehungsweise an einem Ende und am anderen Ende der Leitungskrümmung, beziehungsweise des Umlenkbereichs 4, insbesondere des Signalleiters 10, hat der Signalleiter 10 die Breite W. Damit ist die Leitung am Anfang und am Ende auf die benötigte Leitungsimpedanz angepasst. Über die Krümmungswinkel von vorzugsweise 0° bis 90° verändert sich die Breite W vorzugsweise kontinuierlich. Bevorzugt hat der Signalleiter im Bereich des halben Krümmungswinkels zwischen 35° und 60° seine minimale Breite $W_{min}$. Im Fall einer asymmetrischen Ausbildung des Umlenkungsbereichs kann die minimale Breite $W_{min}$ allerdings auch oberhalb von 60° oder unterhalb von 35° liegen. Im weiteren Verlauf steigt die Breite wieder an, um am Ende bei 90° wieder die Breite W zu erreichen. Auf diese Weise wird ein im Vergleich zu Leiterbahnen aus dem Stand der Technik, welche beispielsweise in Fig. 7 gezeigt ist, ein besseres Übertragungsverhalten bei hohen Frequenzen erreicht.

Der Signalleiter 1 mit zwei gekrümmten Kanten und einer im Vergleich zu den Enden schmaleren Breite im Umlenkbereich kann unterschiedlich ausgebildet sein. Vorzugsweise weisen die Krümmung der Innenkante 3 und die Krümmung der Außenkante 2 eine ellipsen-, oder kreisförmige Kontur auf. Es ist daher denkbar, dass der Mittelpunkt des durch die Innenkante 3 gebildeten Kreises näher am Signalleiter angeordnet ist, als der Mittelpunkt des durch die Außenkante 2 gebildeten Kreises.

Dabei kann, wie in Fig. 8a gezeigt, der von der Außenkante 2 geformte Kreisabschnitt kleiner als 90° sein, oder vorzugsweise auch größer als 90° sein. Gleichfalls, kann der Winkel zwischen der Innenseite der Außenkante 2 und einer durch die Breite des Signalleiters 10 definierten Linie am Beginn der Krümmung der Außenkante 2 einen Wert von 90° oder weniger aufweisen. Der Winkel zwischen der Innenseite der Innenkante 3 und einer durch die Breite des Signalleiters 10 definierten Linie am Beginn der Krümmung der Innenkante 3 kann einen Wert von 90° oder weniger aufweisen. Dabei ist es möglich, dass der Begin der Krümmung der Außenkante 2 in Richtung der Länge des Signalleiters 10 versetzt gegenüber dem Beginn der Krümmung der Innenkante 3 angeordnet ist, vorzugsweise derart, dass zumindest die Außenkante und/oder die Innenkante 3 zumindest einen graden, insbesondere nicht gekrümmten Abschnitt im Umlenkbereich 4 aufweist.

Fig. 8b zeigt eine andere Geometrie des Signalleiters 10, wobei der Winkel zwischen der Innenseite der Außenkante 2 und der durch die Breite des Signalleiters 10 definierten Linie am Beginn der Krümmung der Außenkante 2 einen Wert von 90° oder mehr aufweist. Der von der Außenkante 2 geformte Kreisabschnitt ist dann kleiner als 90° oder vorzugsweise genau 90°. Der Winkel zwischen der Innenseite der Innenkante 3 und der durch die Breite des Signalleiters 10 definierten Linie am Beginn der Krümmung der Innenkante 3 kann einen Wert von 90° oder mehr aufweisen. In diesem Fall ist der von Innenkante 3 gebildete Kreisabschnitt größer als 90°, bevorzugt größer als 130°, bevorzugt größer als 180°. Es kann denkbar sein, dass der Begin der Krümmung der Außenkante 2 versetzt gegenüber dem Beginn der Krümmung der Innenkante 3 angeordnet ist, vorzugsweise derart, dass zumindest die Außenkante und/oder die Innenkante 3 einen graden, insbesondere nicht gekrümmten Abschnitt im Umlenkbereich 4 aufweist.

In Fig. 9 ist dargestellt, wie eine bevorzugte Breite $W_{min}$ im Umlenkbereich 4 ermittelt werden kann. Abgebildet ist eine Konstruktion mit einer Leiterbahn, wie sie in Fig. 7 vorgestellt ist, mit konstanter Leitungsbreite W in der Leitungskrümmung im Umlenkbereich 4. Weiterhin ist ein Hilfskreis 34 gezeigt. Der Mittelpunkt des Hilfskreises 34 ist dadurch definiert, dass der Abstand des Kreismittelpunktes zu den äußeren Kontur-, beziehungsweise Kantenpunkten 33 der Leitungskrümmung am Anfang, beziehungsweise einem Ende 35 und am anderen Ende 36 der Krümmung, beziehungsweise des Umlenkbereichs 4 gleich groß ist. Die beiden Konturpunkte 33 sind gestrichelt umkreist. Ist der Radius $R_h$ des Hilfskreises 34 größer als der Radius der Außenkante 2 des Signalleiters 10, schneidet der Hilfskreis 34 von der Leitungskrümmung eine sichelartige Fläche 40 ab. Eine bevorzugte Leitungskrümmung entsteht nun durch Subtraktion der Sichelfläche 40 von der Leitungskrümmung. Die Sichelfläche 40 besteht aus zwei Kreissegmenten unterschiedlicher Radien. Der Abstand dieser beiden Kreissegmente ist bei den Krümmungswinkeln 0° und 90° null und beim Krümmungswinkel von 45° maximal. Das bedeutet, das bei 0° und 90° die Leitungskrümmung nicht beschnitten wird. Am Anfang 35 und am Ende 35 des Umlenkbereichs 4 bleibt die Breite W des Signalleiters gleich, beziehungsweise unverändert. Insbesondere beim Krümmungswinkel 45° wird hingegen am meisten von der Leitungskrümmung abgeschnitten. Dort ist die Breite $W_{min}$ des Signalleiters 10 vorzugsweise minimal.

Abhängig vom Trägermaterial, der gewünschten Leitungsimpedanz und des Kurvenradius der Leitungskrümmung ist durch Simulationen ein passender Radius $R_h$ des Hilfskreises 34 ermittelbar. Dieser stellt typischerweise einen Kompromiss aus der Verschiebung der Grenzfrequenz der Wellen höherer Ordnung und der benötigten Reflexionsdämpfung dar. Es ist allerdings auch denkbar, dass statt des Hilfskreises 34 eine Ellipse oder eine Parabel verwendet wird. Dabei ist jedoch wichtig, dass die Hilfsfläche von einer stetigen Funktion gebildet wird, um abrupte Änderungen zu vermeiden und dass die Außenkante des Signalleiters 10 die Hilfsfläche an zumindest zwei Punkten schneidet. Anhand derartiger Simulationen und deren Ergebnisse soll im Folgenden der Vorteil der im Umlenkbereich 4 verminderten Breite $W_{min}$ des Signalleiters 10 belegt werden.

Anhand der Fig. 8a, 8b und 9 ist ersichtlich, dass eine günstige Form des Signalleiters 10 ohne Beschränkung auf die speziellen dargestellten Beispiele erhalten werden kann, wenn die Außenkante und die Innenkante Segmente nicht konzentrischer Kurven, insbesondere nicht konzentrischer Kreise oder Ellipsen darstellen. Demgemäß besitzen die Krümmung, beziehungsweise der Kurvenverlauf der Innenkante 3 und die Krümmung der Außenkante jeweils ein Zentrum, wobei das Zentrum der Krümmung der Innenkante 3 und das Zentrum Krümmung der Außenkante versetzt zueinander angeordnet sind, insbesondere sodass die Krümmung der Innenkante 3 und die Krümmung der Außenkante 2 exzentrisch ausgebildet sind. Insbesondere kann dazu das Zentrum der Kurve der Innenkante 3 näher zum Signalleiter 10 angeordnet sein, als das Zentrum der Kurve der Außenkante 2. Dies ist auch bei beiden Konfigurationen der Fig. 8 der Fall. Bei den Beispielen liegt dieser Versatz der Zentren entlang der Winkelhalbierenden der Umlenkung, was bei kreissegmentförmigen Außen- und Innenkanten zu einer in Bezug auf die Winkelhalbierende spiegelsymmetrischen Form des Umlenkbereichs, vorzugsweise auch des ganzen Signalleiters führt.

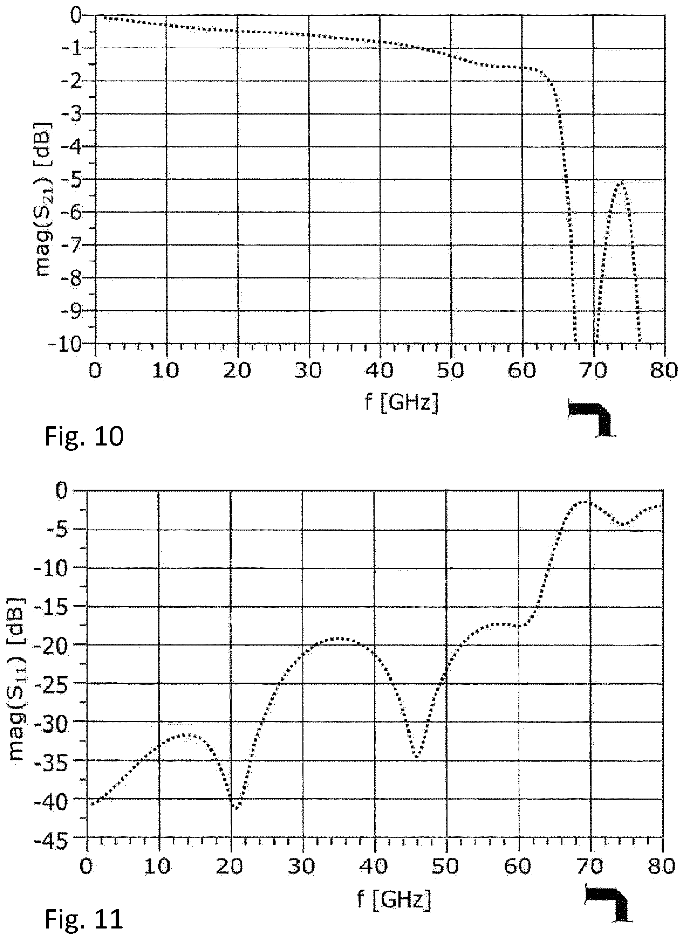

In den Figuren 10, 12, 14, 16 und 18 werden daher die Einfügungsdämpfung und in den Figuren 11, 13, 15, 17 und 19 die Reflexionsdämpfung des aus dem Stand der Technik bekannten 90° Leitungswinkel mit einer 45° Anschrägung 8, wie sie in Fig. 1 dargestellt ist, sowie die Leitungskrümmung mit konstanter Leitungsbreite W aus Fig. 7 dargestellt. Die Einfügungsdämpfung und die Reflexionsdämpfung, welche mit der erfindungsgemäßen Ausgestaltung der Krümmung des Signalleiters 10 im Umlenkbereich 4, erreicht werden kann, wobei beide Kanten 2, 3 gekrümmt sind und die Breite $W_{min}$ des Signalleiters im Umlenkbereich 4 kleiner ist als die Breite W an den Enden 35, 36 des Umlenkbereichs 4 ist ebenfalls dargestellt. Zur besseren Veranschaulichung und Vergleichbarkeit der Diagramme wurden jeweils passende Piktogramme eingefügt, die die jeweilige der zuvor genannten drei Ausbildungen des Signalleiters zeigen, mit der die dargestellten Ergebnisse erzielt wurden. Die Piktogramme entsprechen dabei den in den Figuren 1, 7 und 8, Teilbilder a, b gezeigten Ausführungsformen der Signalleiters 10.

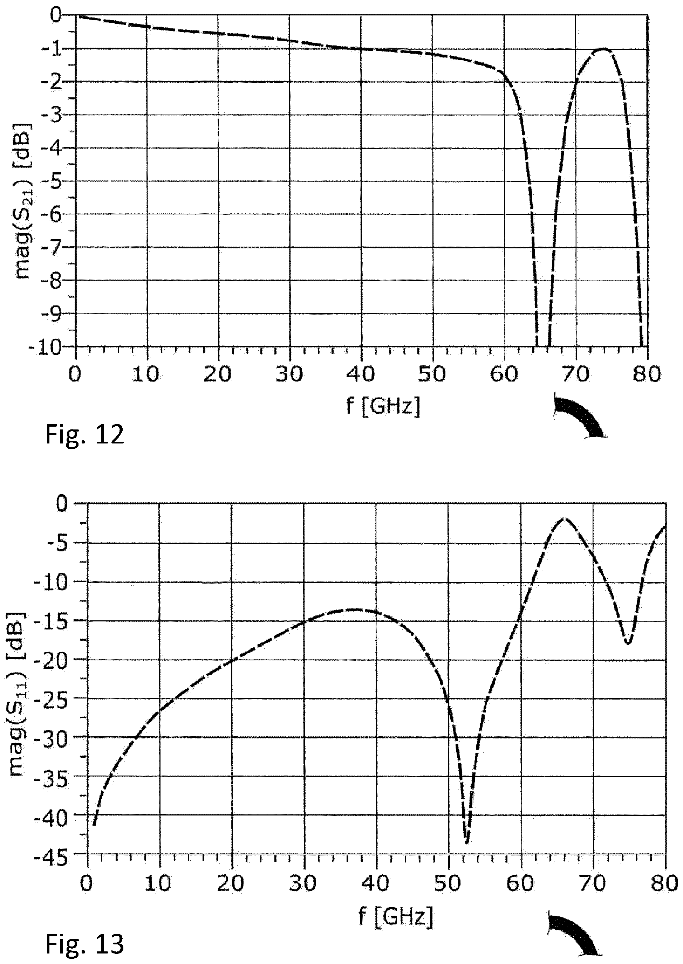

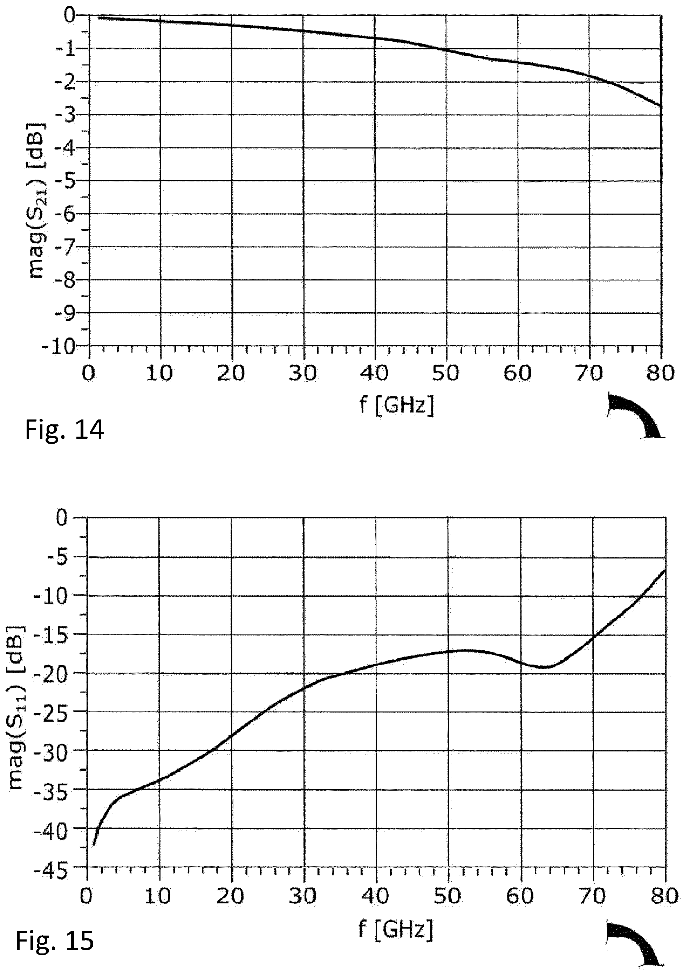

Die Fig. 10 bis 15 zeigen dazu den Verlauf der die Signaldämpfung beschreibenden Streuparameter $S_{21}$ und $S_{11}$ an einem Transistor Outline Header (TO Header) mit einer an eine Durchführung angeschlossenen Signalleitung. Die erfindungsgemäße Leitungskrümmung in den Figuren 14 und 15 zeigt deutlich bessere Eigenschaften bei hohen Frequenzen als der aus dem Stand der Technik bekannte Leitungswinkel (Fig. 10 und 11), beziehungsweise -Krümmung mit konstanter Leitungsbreite (Fig. 12 und 13). In der Einfügungsdämpfung markieren singuläre Stellen dabei die Grenzfrequenz für Wellen höherer Ordnung. Bei den zwei bekannten Umlenkungen eines Signalleites liegt die untere Grenzfrequenz bei ca. 65-70 GHz. Bei der Leitungskrümmung mit verringerter Breite $W_{min}$ und gekrümmten Kanten 2, 3 liegt die Grenzfrequenz vorteilhafterweise bei über 80 GHz, beziehungsweise nicht mehr im Messbereich. Die Grenzfrequenz wird also durch die verringerte Breite $W_{min}$ im Umlenkbereich 4 und die Krümmung der Kanten 2, 3 zu deutlich höheren Werten verschoben, sodass die Grundwelle bei höheren Frequenzen nicht mehr durch Wellen höherer Ordnung beeinträchtigt wird, als dies mit Signalleitern aus dem Stand der Technik möglich ist.

Da die Leitungskrümmung mit konstanter Leiterbahnbreite W die erhöhte Kapazität der Ecke nicht kompensieren kann, ist die Reflexionsdämpfung insgesamt größer als die des 90° Leitungswinkels mit 45° Anschrägung. Bei der Leitungskrümmung mit verringerter Breite $W_{min}$ und gekrümmten Kanten 2, 3 kann die erhöhte Kapazität jedoch sehr gut kompensiert werden und zeigt daher auch eine verbesserte Reflexionsdämpfung im Vergleich zur 45° Anschrägung 8 oder der konstanten Breite. Die Diagramme zeigen, dass der Leitungswinkel mit 45° Anschrägung 8 und die Leitungskrümmungen mit konstanter Breite über der Grenzfrequenz nicht mehr für eine ungestörte Signalübertragung zu verwenden ist.

Um die Anwendungsbreite eines Signalleiters 10 mit verbesserter Leitungskrümmung mit verringerter Breite $W_{min}$ und gekrümmten Kanten 2, 3 zu zeigen, wurde die Simulation mit zwei unterschiedlichen Trägerplatinen durchgeführt.

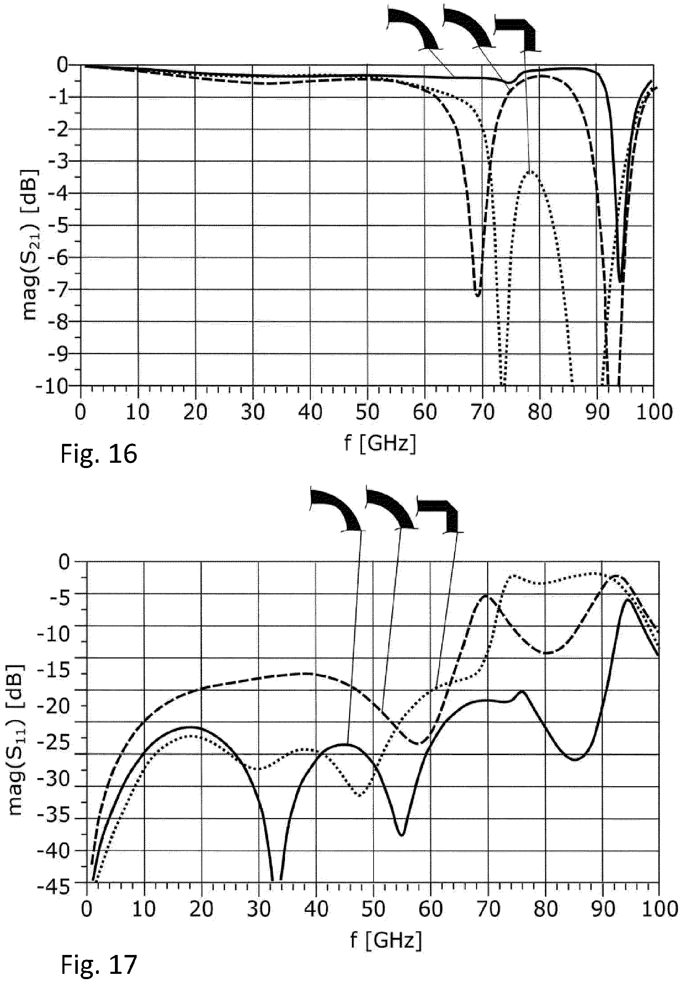

In den Fig. 10 bis 15 und auch den Diagrammen der Fig. 16 bis 19 sind die Frequenzverläufe der Streuparameter für die verschiedenen Formen der Signalleiter anhand der Liniendarstellung gekennzeichnet. Die Frequenzverläufe an der bekannten Anordnung mit einer 45°-Abschrägung sind jeweils mit gepunkteter Linie, die Verläufe an einem gekrümmten Signalleiter mit konstanter Breite mit gestrichelter Linie und die Verläufe an einem gekrümmten Signalleiter mit variabler Breite mit durchgezogener Linie dargestellt. Zusätzlich sind die jeweiligen Kurven mit Piktogrammen gekennzeichnet, welche die verschiedenen Leiterbahnformen darstellen. In Fig. 16 sind die Einfügungsdämpfungen der Simulationsergebnisse dargestellt, bei denen die Simulation mit einer Trägerplatine, beziehungsweise einem Submount mit einer Dicke, beziehungsweise Höhe von 0,2mm durchgeführt wurde. Fig. 17 zeigt die entsprechenden Ergebnisse der Reflexionsdämpfung für die zu Fig. 16 genannten Eigenschaften.

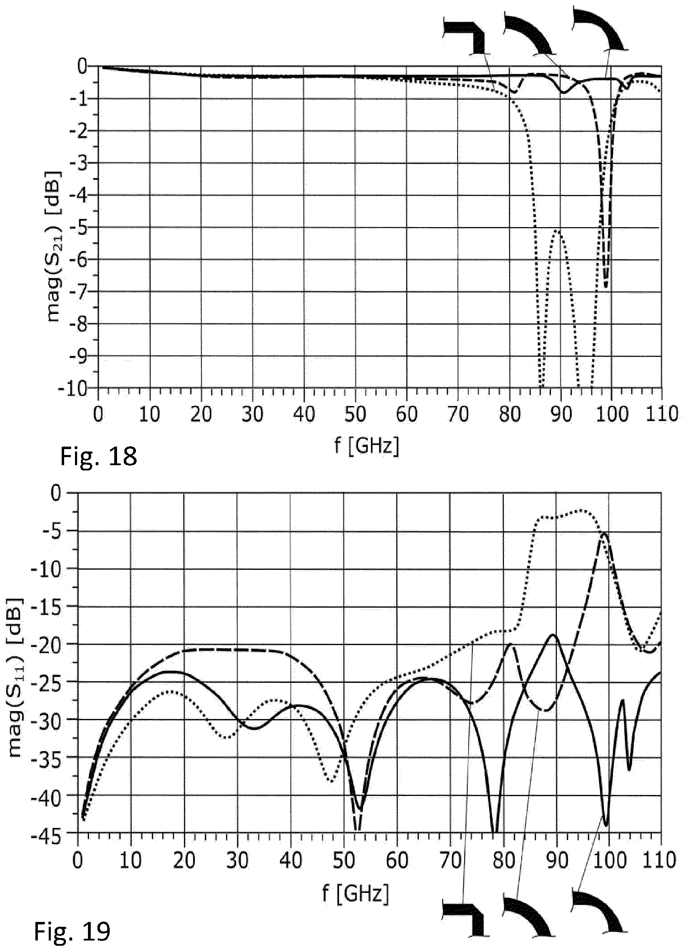

Fig. 18 zeigt die Einfügungsdämpfung mit einem Submount mit einer Höhe von 0,15mm. Fig. 19 zeigt die entsprechenden Ergebnisse der Reflexionsdämpfung für die zu Fig. 18 genannten Eigenschaften.

Die in Fig. 16, 17 und 18, 19 vorgestellten Simulationen unterscheiden sich demnach in für eine Anwendung in TO typischen Werten der Höhe, beziehungsweise der Dicke des Submounts und der Breite des Signalleiters. In den Fig. 16 bis 19 ist deutlich zu erkennen, dass die Grenzfrequenz für die Anregung von Wellen höherer Ordnung bei einer 45° Anschrägung und einer konstanten Leiterbahnbreite bereits bei etwa 70 GHz liegt, wobei die Grenzfrequenz bei Verwendung eines dünneren Submounts zwischen 80 und 100 GHz liegt. Die Grenzfrequenz bei einem Signalleiter 10 mit verringerter Breite $W_{min}$ und gekrümmten Kanten 2, 3 liegt hingegeben in allen Fällen deutlich höher. Hier ist die Grenzfrequenz um etwa 20 GHz und mehr erhöht. Im Falle des dünnen Submounts ist bei etwa 90 GHz ein sehr geringer Knick in der Einfügungsdämpfung erkennbar, der auf eine Grenzfrequenz hinweist, die aber durch geeignete Wahl der Breite $W_{min}$ bis zur Bedeutungslosigkeit minimiert werden kann. Auch in der Reflexionsdämpfung sind im Vergleich zu einer 45° Anschrägung und einer konstanten Leiterbahnbreite verbesserte Werte deutlich erkennbar.

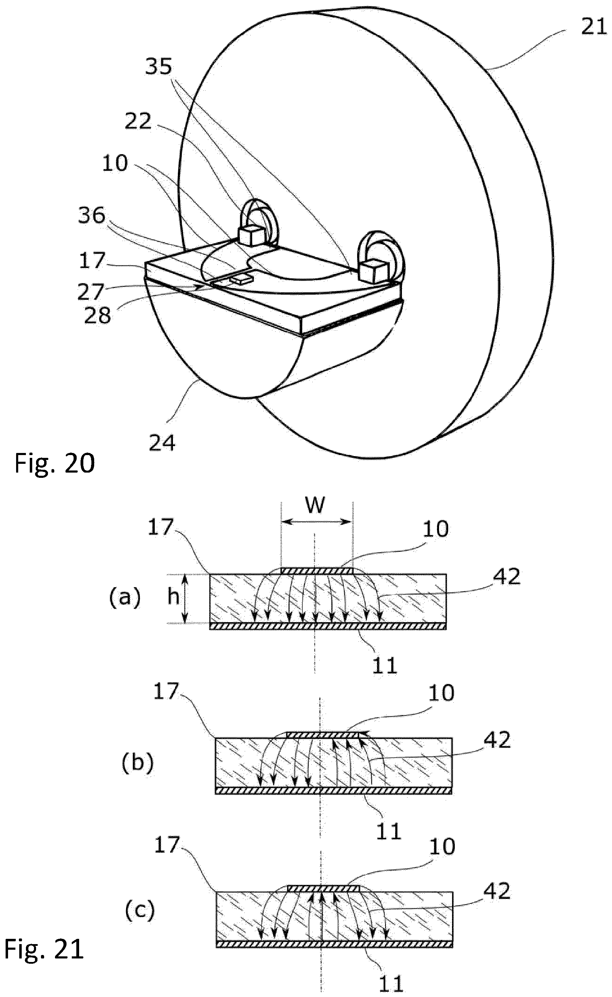

Fig. 20 zeigt schematisch einen Signalleiter 10 mit verringerter Breite $W_{min}$ und gekrümmten Kanten 2, 3 in Verwendung mit einer weiteren elektronischen Komponente mit einem Sockel 20 und seiner Basis 21 zeigt. Als elektronisches Bauelement 28 kann eine elektronische Komponente, vorzugsweise ein optoelektronischer Wandler, insbesondere eine Laserdiode oder ein Lichtsensor vorgesehen sein, so wie es auch in Fig. 6 beschrieben ist. Das elektronische Bauelement 28 kann ohne Beschränkung auf das hier dargestellte Beispiel an zwei Signalleiter 10 angeschlossen sein, welche mit jeweils einem Pin zur weiteren Signalübertragung elektrisch verbunden sein können. Um eine gute Reflexionsdämpfung zu erreichen, ist es generell vorteilhaft, wenn jeweils ein Ende 35 des Umlenkbereichs, beziehungsweise des Signalleiters 10 elektrisch mit einem Pin und ein anderes Ende 36 elektrisch mit dem Bauteil 28 gekoppelt ist. Die Umlenkung dient typischerweise dazu, den oder die Signalleiter 10 vom Pin in Richtung zum Bauelement 28 zu führen.

Vorzugsweise sind die Signalleiter 10 elektrisch, beispielsweise durch einen Spalt 27 voneinander getrennt, beziehungsweise entkoppelt. Zumindest ein Signalleiter kann vorzugsweise mit zumindest einem Bonddraht elektronisch mit dem Bauelement 28 verbunden sein. Typischerweise ist vorgesehen, dass der andere Signalleiter direkt, insbesondere ohne Bonddraht, mit einem Anschluss des Bauelements gekoppelt ist. Eine Umlenkung des Signalleiters 10, wie sie in dieser Offenbarung beschrieben wird, kann etwa dann von Vorteil sein, wenn das elektronische Bauelement 28 thermisch vom Sockel 20 entkoppelt werden soll, so wie es in Fig. 6 dargestellt ist. Dazu kann vorgesehen sein, dass das Bauelement 28 auf einem Podest 24 angeordnet ist, welches mit, thermoelektrischen Kühler 26 gekühlt wird. Bevorzugt wird allerdings, anders als in Fig. 6 dargestellt, dass das elektronische Bauelement 28 ohne einen thermoelektrischen Kühler 26 gekühlt wird und insbesondere thermisch mit dem Podest 24 gekoppelt ist. Auf dem Podest 24 ist weiterhin vorzugsweise ein Submount oder ein Träger 16 angeordnet, auf dessen Oberseite der oder die Signalleiter 10 angeordnet sind. An der Unterseite des Trägers 16, insbesondere mit elektrischem Kontakt zum Podest 24 ist zwecks Erdung ein Masseleiter angeordnet, sodass die Leiterbahnanordnung 1 als Microstrip-Line oder auch als CBCPW-Anordnung ausgebildet sein kann.

Die Leiterbahnanordnung 1, beziehungsweise der oder die Signalleiter 10 weisen einen Umlenkbereich 4 auf, wobei die Breite $W_{min}$ im Umlenkbereich 4 zumindest abschnittsweise kleiner ist, als die Breite W an zumindest einem der Enden 35, 36 des Umlenkbereichs 4. Bevorzugt sind die Kanten 2, 3, insbesondere die Außen-2 und Innenkante 3 zumindest eines Signalleiters 10, bevorzugt von beiden Signalleitern 10 zumindest abschnittsweise, insbesondere kontinuierlich gekrümmt. Dabei ist die Krümmung der Innenkante 3 und die Krümmung der Außenkante 3 vorzugsweise exzentrisch ausgebildet, sodass der Radius der Krümmung der Außenkante 2 größer ist, als der Radius der Krümmung der Innenkante 3. Der Umlenkbereich 4 kann sich von einem Ende bis zum anderen Ende des oder der Signalleiter erstrecken.

Um die Wirkungsweise und insbesondere den Effekt der zuvor beschriebenen Leiterbahnanordnung zu verstehen, wird im Folgenden die Entstehung von Wellen höherer Ordnung auf einer Microstrip-Line, wie sie beispielsweise in Fig. 2 und 20 beschrieben ist, kurz erläutert. Fig. 21 zeigt dazu in drei Teilbildern eine Microstrip-Line im Querschnitt und die sich ausbildenden Feldlinien 42 zwischen dem Signalleiter 11 und dem gegenüberliegend auf dem Submount 17 angeordneten Masseleiter 11 Der Submount 17 hat eine Höhe h, die klein gegen ¼ der Wellenlänge ist. Aus diesem Grund existieren keine höheren Wellen in vertikaler Richtung. In horizontaler Richtung können Wellen höher Ordnung allerdings ausbreitungsfähig sein, wenn die Breite W in die Größenordnung von einem Vielfachen der halben Wellenlängen ($n \lambda/2$) kommt. In diesem Fall können sich weitere stehende Wellen in transversaler Richtung bilden. Daher gibt es eine Grenzfrequenz, ab der sich Wellen höherer Ordnung ausbreiten, beziehungsweise existieren können. Wellen höherer Ordnung können auch durch Störungen des Signalleiters angeregt werden.

Die Microstrip-Line hat eine inhomogene Stofffüllung und führt daher keine reine transversalelektromagnetische Welle (TEM Welle). Allerdings verhalten sich die Grundwellen über weite Frequenzbereiche nahezu wie eine TEM Welle und werden daher auch als Quasi-TEM Wellen bezeichnet. Diese können gut zur Signalübertragung genutzt werden. Bei diesen Grundwellen, beziehungsweise Quasi-TEM Wellen sind die Feldlinien des elektrischen Feldes (E-Feld), wie in Teilbild (a) gezeigt über den Querschnitt des Signalleiters 10, beziehungsweise über die Breite des Signalleiters 10 in dieselbe Richtung gerichtet, also konstant. Die Feldlinien der Wellen höherer Ordnung wechseln über die Breite des Signalleiters 10 hingegen ihre Richtung, sodass zwischen derartigen Richtungswechseln das E-Feld verschwindet. Die Teilbilder (b) und (c) zeigen dazu die Feldlinien der beiden ersten Oberwellen, beziehungsweise Wellen höherer Ordnung.

Die Grundwelle und alle Wellen höhere Ordnung werden als Eigenwellen der Signalleiters 10 bezeichnet. Auf einer ungestörten Leitung bewegen sich die Eigenwellen unabhängig voneinander und stören sich nicht. Bei einer Störung, wie beispielsweise einer Richtungsänderung oder einem Knick des Signalleiters, tritt eine Verkopplung der Eigenwellen, also der Grundwellen und der Wellen höherer Ordnung auf. Hierdurch ändern sich die Eigenschaften der Grundwelle, sobald sich eine Welle höherer Ordnung ausbreitet.

Die zuvor beschriebene Microstrip-Line hat nun den Vorteil, dass sie eine im Vergleich zu komplexeren Leiterbahnsystemen, wie CBCPW-Anordnungen einfache Bauweise aufweist und die Eigenschaften der Eigenwellen maßgeblich durch die Geometrie des Signalleiters 10, insbesondere durch die Krümmung und die Breite, beziehungsweise den Querschnitt des Signalleiters 10 beeinflusst wird, sowie durch die Dicke des Submounts, beziehungsweise der Trägerplatine des Signalleiters 10. Ohne Beschränkung auf die hier diskutierten Beispiele, wird dieser Zusammenhang anhand einiger Beispielwerte erläutert. Die Grenzfrequenz der Wellen höherer Ordnung liegt umso tiefer, je größer die Breite des Signalleiters ist. Ist die Leitungsimpedanz etwa die Hälfte der sonst üblichen 50 Ω, also nur 25 Ω, bei gleicher Trägerplatine, so ist die 25 Ω Leitung dreimal breiter als eine 50 Ω Leitung. Die Grenzfrequenz für Wellen höherer Ordnung ist bei einer 25 Ω Leitung daher um ein Drittel niedriger als bei einer üblichen 50 Ω Leitung.

Wie in den Figuren 10 bis 19 gezeigt ist, konnte die Grenzfrequenz der Wellen höherer Ordnung durch die, insbesondere in den Figuren 8a, b, 9 und 20 vorgestellten Ausführungsformen zu hohen Frequenzwerten verschoben, beispielsweise über 80 GHz werden, sodass die Grundwellen, also die Signalleitung bis zu Frequenzwerten bis 80 GHz, vorzugsweise bis zu 90 GHz, vorzugsweise sogar bei Werten oberhalb von 100 GHz nur wenig gestört, oder sogar gar nicht gestört wird.

Die Erfindung wird durch die Ansprüche definiert.

Bezugszeichenliste

| | |
|---|---|
| 1 | Leiterbahnanordnung |
| 2 | Außenkante des Signalleiters 10 |
| 3 | Innenkante des Signalleiters 10 |
| 4 | Umlenkbereich |
| 5 | Umlenkabschnitt von 2 |
| 6 | Umlenkabschnitt von 3 |
| 7 | Submount |
| 8 | Anschrägung |
| 10 | Signalleiter |
| 11 | Masseleiter |
| 12 | Ecke |
| 13, 14 | Schenkel |
| 16 | Träger |

(fortgesetzt)

| 17 | Submount |
|---|---|
| 18 | Spalt in 4 |
| 20 | Sockel |
| 21 | Basis von 20 |
| 22 | Durchführung |
| 24 | Podest |
| 26 | Thermoelektrischer Kühler |
| 27 | Spalt |
| 28 | Elektronisches Bauelement |
| 29 | Bonddraht |
| 30 | Elektronische Komponente |
| 31 | Kappe |
| 32 | Fenster |
| 33 | Äußere Konturpunkte |
| 34 | Hilfskreis |
| 35 | Ein Ende des Umlenkbereichs |
| 36 | Anderes Ende des Umlenkbereichs |
| 40 | Sichelartige Fläche |
| 42 | Feldlinie |
| $\alpha$ | Umlenkwinkel |
| H | Dicke von 1 |
| W | Breite von 10 |
| $W_{min}$ | Minimale Breite von 10 an einem Ende von 1 |
| D | $\sqrt{2} \times W$ |
| $R_h$ | Radius des Hilfskreises |
| X | Gehrung |
|  |  |

**Patentansprüche**

1. Leiterbahnanordnung (1) für hochfrequente Signale, mit einem Träger (16) und einem auf dem Träger (16) angeordneten, durch zumindest eine Innenkante (3) und zumindest eine Außenkante (2) begrenzten schichtförmigen flachen Signalleiter (10), welcher sich von einem Ende zu einem anderen Ende des Signalleiters (10) erstreckt, wobei der Signalleiter (10) der Leiterbahnanordnung (1) in einem Umlenkbereich (4) zwischen den Enden seine Richtung ändert und eine minimale Breite ($W_{min}$) aufweist, wobei die minimale Breite ($W_{min}$) im Umlenkbereich (4) des Signalleiters (10) kleiner ist, als die Breiten (W) an den Enden des Signalleiters (10), und wobei die Außenkante (2) und die Innenkante (3) im Umlenkbereich (4) zumindest abschnittsweise gekrümmt sind, wobei die Krümmung der Innenkante (3) und die Krümmung der Außenkante (2) jeweils ein Zentrum besitzen, **dadurch gekennzeichnet, dass** das Zentrum der Krümmung der Innenkante (3) und das Zentrum der Krümmung der Außenkante (2) versetzt zueinander angeordnet sind, sodass die Krümmung der Innenkante (3) und die Krümmung der Außenkante (2) exzentrisch ausgebildet sind und wobei die Kontur der Außenkante (2) im Umlenkbereich insgesamt konvex ist und die Kontur der Innenkante (3) insgesamt konkav ist.

2. Leiterbahnanordnung (1) gemäß einem der vorstehenden Ansprüche,
**gekennzeichnet durch** zumindest eines der folgenden Merkmale:

   - die Krümmung der Außenkante (2) und/oder der Innenkante (3) ist kontinuierlich, insbesondere ununterbrochen ausgebildet,
   - die Krümmung der Außenkante (2) und/oder der Innenkante (3) ist stetig,
   - die Breite des Signalleiters (10) ändert sich im Umlenkbereich (4) stetig,
   - die minimale Breite ($W_{min}$) des Signalleiters (10) liegt innerhalb des mittleren Drittels des Umlenkbereichs (4), vorzugsweise in der Mitte des Umlenkbereichs (4).

3. Leiterbahnanordnung (1) gemäß einem der vorstehenden Ansprüche, **dadurch gekennzeichnet, dass** sich der Umlenkbereich (4) von einem Ende bis zum anderen Ende des Signalleiters erstreckt.

4. Leiterbahnanordnung (1) gemäß einem der vorstehenden Ansprüche, **gekennzeichnet durch** eines der folgenden Merkmale:

   - der Umlenkbereich (4) ist asymmetrisch geformt,
   - der Umlenkbereich (4) weist eine Spiegelachse entlang der Winkelhalbierenden des Umlenkbereichs auf.

5. Leiterbahnanordnung (1) gemäß einem der vorstehenden Ansprüche, **dadurch gekennzeichnet, dass** der Signalleiter (10) im Umlenkbereich (4) um einen Winkel im Bereich von 75° bis 105°, vorzugsweise um einen Winkel von 90° umgelenkt wird.

6. Leiterbahnanordnung (1) gemäß einem der vorstehenden Ansprüche, **dadurch gekennzeichnet, dass** die Leiterbahnanordnung (1) als Microstrip-Line, als koplanarer Wellenleiter oder als CBCPW-Anordnung ausgebildet ist.

7. Leiterbahnanordnung gemäß einem der vorstehenden Ansprüche, **dadurch gekennzeichnet, dass** die Leiterbahnanordnung (1) einen schichtförmigen Masseleiter (11) umfasst, welcher gegenüber dem schichtförmigen flachen Signalleiter (10) angeordnet ist, wobei für den Abstand zwischen Masseleiter (11) und Signalleiter (10) zumindest eines der folgenden Merkmale gilt:

   - der Abstand liegt im Bereich von 0,025 mm und 0.5mm, vorzugsweise im Bereich von 0,05 mm bis 0,4mm,
   - die Breite (W) an einem Ende (35, 36) des Signalleiters (10) ist um einen Faktor im Bereich von 0.5 bis 7,5, vorzugsweise in einem Bereich von 0.6 bis 5 größer als der Abstand zwischen Masseleiter (11) und Signalleiter (10),
   - das Verhältnis des Abstands zwischen Signalleiter (10) und Masseleiter (11) zur Differenz der Breite (W) des Signalleiters (10) an einem seiner Enden (35, 36) und der minimalen Breite ($W_{min}$) des Signalleiters (1) hat einen Wert im Bereich von 0,5 bis 2,
   - die Leiterbahnanordnung (1) ist derart ausgebildet ist, dass eine Grenzfrequenz, insbesondere eine Grenzfrequenz für die Entstehung von Wellen höherer Ordnung oberhalb von 60 GHz, vorzugsweise oberhalb von 70 GHz liegt.

8. Leiterbahnanordnung (1) gemäß einem der vorstehenden Ansprüche,
**gekennzeichnet durch** zumindest eines der folgenden Merkmale:

   - die Leiterbahnanordnung (1) ist auf einem Submount (17) angeordnet,
   - der Träger (16) umfasst Aluminiumnitrid-Keramik, eine Aluminiumnitrid enthaltende Keramik, Glas, oder Glas und Keramik.

9. Sockel (20) für eine elektronische Komponente mit einem elektronischen Bauelement (28) und einer Leiterbahnanordnung (1) gemäß einem der vorstehenden Ansprüche, wobei der Sockel eine elektrische Durchführung (22) aufweist, und wobei das elektronische Bauelement (28) und die elektrische Durchführung (22) beide mit dem Signalleiter (10) der Leiterbahnanordnung (1) verbunden sind, so dass elektrische Signale von der Durchführung (22) über den Signalleiter (10) zum Bauelement (28) geleitet werden.

10. Elektronische Komponente (30) in Form eines Bauteils mit einem Gehäuse, in welchem ein elektronisches Bauelement (28) und die Leiterbahnanordnung (1) gemäß einem der vorhergehenden Ansprüche eingeschlossen sind.

**Claims**

1. A conductor track arrangement (1) for high-frequency signals, comprising a substrate (16) and a layer-shaped, flat signal conductor (10) arranged on said substrate (16) and delimited by at least one inner edge (3) and at least one outer edge (2) and extending from one end to another end of the signal conductor (10), with the signal conductor (10) of the conductor track arrangement (1) changing its orientation within a deflection area (4) between said ends and having a minimum width ($W_{min}$), said minimum width ($W_{min}$) in the deflection area (4) of the signal conductor (10) being smaller than the widths (W) at the ends of the signal conductor (10), and the outer edge (2) and inner edge (3) being curved in the deflection area (4), at least in sections thereof, the curvature of the inner edge (3) and the curvature of the outer edge (2) each having a centre;
**characterized in that** the centre of the curvature of the inner edge (3) and the centre of the curvature of the outer edge (2) are offset from one another, so that the curvature of the inner edge (3) and the curvature of the outer edge (2) are shaped eccentrically, and wherein the contour of the outer edge (2) is overall convex and the contour of the inner edge (3) is overall concave in the deflection area.

2. The conductor track arrangement (1) according to any one of the preceding claims, **characterized by** at least one of the following features:

   - the curvature of the outer edge (2) and/or of the inner edge (3) is continual, in particular uninterrupted;
   - the curvature of the outer edge (2) and/or of the inner edge (3) is continuous;
   - the width of the signal conductor (10) changes continuously within the deflection area (4);
   - the minimum width ($W_{min}$) of the signal conductor (10) is within the middle third of the deflection area (4), preferably in the middle of the deflection area (4).

3. The conductor track arrangement (1) according to any one of the preceding claims, **characterized in that** the deflection area (4) extends from one end to the other end of the signal conductor.

4. The conductor track arrangement (1) according to any one of the preceding claims, **characterized by** any of the following features:

   - the deflection area (4) is shaped asymmetrically;
   - the deflection area (4) has a mirror axis along the angle bisector of the deflection area.

5. The conductor track arrangement (1) according to any one of the preceding claims, **characterized in that** the signal conductor (10) is deflected within the deflection area (4) by an angle ranging from 75° to 105°, preferably by an angle of 90°.

6. The conductor track arrangement (1) according to any one of the preceding claims, **characterized in that** the conductor track arrangement (1) is in the form of a microstrip line or a coplanar waveguide or a CBCPW arrangement.

7. The conductor track arrangement according to any one of the preceding claims, **characterized in that** the conductor track arrangement (1) comprises a layer-shaped ground conductor (11) which is arranged opposite the layer-shaped flat signal conductor (10), with at least one of the following features applying to the spacing between the ground conductor (11) and the signal conductor (10):

   - the spacing is in the range from 0.025 mm to 0.5 mm, preferably in the range from 0.05 mm to 0.4 mm;
   - the width (W) at one end (35, 36) of the signal conductor (10) is greater than the spacing between the ground conductor (11) and the signal conductor (10) by a factor in the range from 0.5 to 7.5, preferably in the range from 0.6 to 5;
   - the ratio of the spacing between the signal conductor (10) and the ground conductor (11) to the difference between the width (W) of the signal conductor (10) at one of its ends (35, 36) and the minimum width ($W_{min}$) of the signal conductor (1) has a value in the range from 0.5 to 2;
   - the conductor track arrangement (1) is designed such that a cut-off frequency, in particular a cut-off frequency for the occurrence of higher order wave modes lies above 60 GHz, preferably above 70 GHz.

8. The conductor track arrangement (1) according to any one of the preceding claims, **characterized by** at least one of the following features:

- the conductor track arrangement (1) is arranged on a submount (17);
- the substrate (16) comprises an aluminium nitride ceramic, a ceramic containing aluminium nitride, glass, or glass and ceramic.

9. A header (20) for an electronic module, comprising an electronic component (28) and a conductor track arrangement (1) according to any one of the preceding claims, wherein the header has an electrical feedthrough (22), and wherein both the electronic component (28) and the electrical feedthrough (22) are connected to the signal conductor (10) of the conductor track arrangement (1), so that electrical signals are conducted from the feedthrough (22) via the signal conductor (10) to the component (28).

10. An electronic module (30) in the form of a component comprising a package which encloses an electronic component (28) and the conductor track arrangement (1) according to any one of the preceding claims.

**Revendications**

1. Dispositif à pistes conductrices (1) pour signaux haute fréquence, comprenant un support (16) et un conducteur de signal (10) plat en forme de couche qui est disposé sur le support (16) et est délimité par au moins un bord intérieur (3) et au moins un bord extérieur (2) et qui s'étend depuis une extrémité jusqu'à une autre extrémité du conducteur de signal (10), le conducteur de signal (10) du dispositif à pistes conductrices (1) changeant de direction entre les extrémités, dans une zone de déviation (4), et présentant une largeur minimale ($W_{min}$), la largeur minimale ($W_{min}$) étant inférieure, dans la zone de déviation (4) du conducteur de signal (10), aux largeurs (W) aux extrémités du conducteur de signal (10), et le bord extérieur (2) et le bord intérieur (3) étant incurvés, au moins par portions, dans la zone de déviation (4), sachant que la courbure du bord intérieur (3) et la courbure du bord extérieur (2) ont chacune un centre, **caractérisé en ce que** le centre de la courbure du bord intérieur (3) et le centre de la courbure du bord extérieur (2) sont disposés en étant décalés l'un par rapport à l'autre, de sorte que la courbure du bord intérieur (3) et la courbure du bord extérieur (2) sont réalisées de façon excentrée, et le contour du bord extérieur (2) étant globalement convexe dans la zone de déviation (4), et le contour du bord intérieur (3) étant globalement concave.

2. Dispositif à pistes conductrices (1) selon une des revendications précédentes, **caractérisé en ce qu'**il présente au moins une des caractéristiques suivantes :

   - la courbure du bord extérieur (2) et/ou du bord intérieur (3) est réalisée sous une forme continue, notamment sans interruptions,
   - la courbure du bord extérieur (2) et/ou du bord intérieur (3) est régulière,
   - la largeur du conducteur de signal (10) varie de façon régulière dans la zone de déviation (4),
   - la largeur minimale ($W_{min}$) du conducteur de signal (10) se situe dans le tiers médian de la zone de déviation (4), de préférence au milieu de la zone de déviation (4).

3. Dispositif à pistes conductrices (1) selon une des revendications précédentes, **caractérisé en ce que** la zone de déviation (4) s'étend depuis une extrémité jusqu'à l'autre extrémité du conducteur de signal.

4. Dispositif à pistes conductrices (1) selon une des revendications précédentes, **caractérisé en ce qu'**il présente une des caractéristiques suivantes :

   - la zone de déviation (4) a une forme asymétrique,
   - la zone de déviation (4) présente un axe de symétrie le long de la bissectrice de la zone de déviation (4).

5. Dispositif à pistes conductrices (1) selon une des revendications précédentes, **caractérisé en ce que** dans la zone de déviation (4), le conducteur de signal (10) est dévié sous un angle compris dans la plage allant de 75° à 105°, de préférence sous un angle de 90°.

6. Dispositif à pistes conductrices (1) selon une des revendications précédentes, **caractérisé en ce que** le dispositif à pistes conductrices (1) est réalisé sous forme de ligne microruban, de guide d'ondes coplanaire ou d'agencement CBPCPW.

7. Dispositif à pistes conductrices selon une des revendications précédentes, **caractérisé en ce que** le dispositif à pistes conductrices (1) comprend un conducteur de masse (11) en forme de couche qui est disposé en vis-à-vis du conducteur de signal (10) plat en forme de couche, la distance entre le conducteur de masse (11) et le conducteur de signal (10) présentant au moins une des caractéristiques suivantes :

- la distance est comprise dans la plage allant de 0,025 mm à 0,5 mm, de préférence dans la plage allant de 0,05 à 0,4 mm,
- la largeur (W) à une extrémité (35, 36) du conducteur de signal (10) est supérieure d'un facteur situé dans la plage de 0,5 à 7,5, de préférence dans une plage de 0,6 à 5, à la distance entre le conducteur de masse (11) et le conducteur de signal (10),
- le rapport de la distance entre le conducteur de signal (10) et le conducteur de masse (11) à la différence entre la largeur (W) du conducteur de signal (10), à une de ses extrémités (35, 36), et la largeur minimale ($W_{min}$) du conducteur de signal (10) présente une valeur située dans la plage allant de 0,5 à 2.
- le dispositif à pistes conductrices (1) est réalisé de manière à ce qu'une fréquence limite, notamment une fréquence limite pour la formation d'ondes d'ordre supérieur, soit supérieure à 60 GHz, de préférence supérieure à 70 GHz.

8. Dispositif à pistes conductrices (1) selon une des revendications précédentes, **caractérisé en ce qu'**il présente au moins une des caractéristiques suivantes :

- le dispositif à pistes conductrices (1) est installé sur une embase (17),
- le support (16) comprend de la céramique de nitrure d'aluminium, une céramique contenant du nitrure d'aluminium, du verre ou du verre et de la céramique.

9. Socle (20) destiné à un élément électronique comprenant un composant électronique (28) et un dispositif à pistes conductrices (1) selon une des revendications précédentes, le socle présentant un passage électrique (22), et le composant électronique (28) et le passage électrique (22) étant tous deux reliés au conducteur de signal (10) du dispositif à pistes conductrices (1), de sorte que des signaux électriques sont conduits depuis le passage (22) au composant (28), en passant par le conducteur de signal (10).

10. Elément électronique (30) sous la forme d'un élément de construction doté d'un boîtier, dans lequel sont enfermés un composant électronique (28) et le dispositif à pistes conductrices (1) selon une des revendications précédentes.

Fig. 1

Fig. 2

Fig. 3

Fig. 4

Fig. 5

Fig. 6

Fig. 7

(a)

(b)

Fig. 8

Fig. 9

Fig. 10

Fig. 11

Fig. 12

Fig. 13

Fig. 14

Fig. 15

Fig. 16

Fig. 17

Fig. 18

Fig. 19

Fig. 20

Fig. 21

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102020105772
- WO 2007000934 A1
- DE 102005038456 A1
- WO 2014089823 A1